# EUROPÄISCHE PATENTSCHRIFT

(11) **EP 0 474 604 B1**
(45) Veröffentlichungstag und Bekanntmachung des Hinweises auf die Patenterteilung: **05.11.1997**
(21) Anmeldenummer: 91810696.4
(22) Anmeldetag: 02.09.1991
(51) Int. Cl.: H01J 37/32, H01J 37/02

(54) **Apparatur zur plasmathermischen Bearbeitung von Werkstückoberflächen**
Apparatus for thermal plasma processing of workpiece surfaces
Appareil pour le traitement thermique par plasma de la surface de pièces

(30) Priorität: 07.09.1990 DE 4028482
(43) Veröffentlichungstag der Anmeldung: 11.03.1992
(73) Patentinhaber: Sulzer Metco AG, 5610 Wohlen (CH)
(72) Erfinder: Hansz, Bernard, F-91710 Vert le Pett (FR); Keller, Silvano, CH-5315 Böttstein (CH)
(74) Vertreter: Rottmann, Maximilian R.

(56) Entgegenhaltungen:
- US-A- 4 675 205
- PATENT ABSTRACTS OF JAPAN vol. 14, no. 273 (E-940)13. Juni 1990
- PATENT ABSTRACTS OF JAPAN vol. 10, no. 56 (C-331)6. März 1986

## Beschreibung

Die Erfindung betrifft eine Apparatur zur plasmathermischen Oberflächenbearbeitung von Werkstücken aus thermisch empfindlichem Material in einer inerten Gasatmosphäre, mit einem gasdichten, den Arbeitsplatz umschliessenden Behälter, einem beweglichen Werkstückträger, einem Plasmatron und Mitteln zur Positionierung desselben bezüglich der mit dem Plasmastrahl fortlaufend zonenweise zu bearbeitenden Werkstückoberfläche sowie mit einer während der Bearbeitung betriebenen Kühlanlage mit einer im Behälter angeordneten Kühlvorrichtung zum Kühlen der jeweils bearbeiteten Werkstückoberflächenzone durch Beaufschlagen Beaufschlagen derselben mit derselben mit einem Kühlmittelstrahl, wobei die Anordnung so getroffen ist, dass die Einwirkungszone des Kühlmittelstrahls der auf der Werkstückoberfläche wandernden Einwirkungszone des Plasmastrahls unmittelbar nachfolgt.

Die Oberflächen von Werkstücken, auch von Werkstücken aus thermisch empfindlichem Material, wie z.B. Kunststoff, lassen sich im plasmathermischen Verfahren bearbeiten, z.B. mit einem Überzug beschichten oder für eine solche Beschichtung vorbereiten, unter der Voraussetzung, dass die jeweils bearbeitete Oberflächenzone unmittelbar nach der Wärmeeinwirkung durch den auf die Werkstückoberfläche gerichteten Plasmastrahl wirksam gekühlt wird. Auf diese Weise gelingt es, die Oberflächentemperatur in den für die Erhaltung der Materialstruktur an der Werkstückoberfläche massgebenden Grenzen zu halten.

In der US-Patentschrift Nr. 4.675.205 ist eine Apparatur der eingangs genannten Art beschrieben, welche für die Bearbeitung von rotationssymmetrischen Werkstücken eingerichtet ist und ein bewegliches Plasmatron mit auf die Werkstückoberfläche gerichtetem Plasmastrahl aufweist. Zur Erzielung einer Kühlwirkung der erwähnten Art ist eine Kühlvorrichtung vorgesehen, die einen auf die Werkstückoberfläche gerichteten Kühlmittelstrom erzeugt. Diese Kühlvorrichtung ist ebenfalls beweglich angeordnet, wobei die Bewegungen der Kühlvorrichtung und die Bewegungen des Plasmatrons derart aufeinander abgestimmt sind, dass die Einwirkungszone des Kühlmittelstromes der auf der Werkstückoberfläche wandernden Einwirkungszone des Plasmastrahls unmittelbar nachfolgt. Da der Bewegungsbereich sowohl des Plasmatrons als auch der Kühlvorrichtung wegen der mit diesen Geräten verbundenen Anschlussleitungen praktisch begrenzt ist, lässt man das Werkstück rotieren, während die Bewegungsbahnen der genannten Geräte nur in jeweils einer die Rotationsachse enthaltenden Ebene verläuft. Als Kühlmittel ist bei der bekannten Apparatur eine Kühlflüssigkeit vorgesehen, die eine Temperatur nahe ihrer Sättigungstemperatur aufweist, und zwar dient als Kühlflüssigkeit ein verflüssigtes Gas (Flüssiggas), z.B. Helium, Stickstoff oder Argon.

Praktische Versuche mit einer Kühlvorrichtung nach den Vorschlägen der US-Patentschrift Nr. 4.675.205 haben ergeben, dass für eine wirksame Kühlung der bearbeiteten Werkstückoberfläche ein ziemlich hoher Durchsatz an Kühlmittel erforderlich ist, obwohl die Temperatur des Flüssiggases extrem niedrig ist und obwohl die Kühlung sich jeweils auf eine verhältnismässig kleine Oberflächenzone beschränkt und die bewegliche Kühlvorrichtung zu diesem Zweck nur eine einzige Ausströmdüse für das Flüssiggas aufweist. Der hohe Verbrauch an teurem Kühlmittel und der konstruktive Aufwand für die kinematische Nachführung der Kühleinrichtung führen zu hohen Kosten für den Aufbau und den Betrieb einer Kühleinrichtung dieser Art.

Aus der Patentschrift JP-A-60.197.877 (Zusammenfassung) ist es bei einem unter Vakuum durchgeführten plasmachemischen Beschichtungsverfahrens bekannt, das Werkstück mit einem geeigneten Gas zu kühlen, das in den Vakuumkessel eingeleitet wird und anschliessend in einem geschlossenen Kühlkreislauf zirkuliert.

Aus der Patentschrift JP-A-2.086.129 (Zusammenfassung) ist ebenfalls eine Apparatur zur plasmachemischen Behandlung von Werkstücken bekannt. Hier wird während des Behandlungsvorgangs ein Teil des der Apparatur zugeführten Plasmagases zuerst an eine nicht zu behandelnde Oberflächenpartie (Rückseite) des Werkstücks herangeführt und zur Kühlung desselben benutzt, bevor dieses Plasmagas die zur Plasmaerzeugung vorgesehene Kammer erreicht.

Die Erfindung bezweckt die Schaffung einer Apparatur der eingangs genannten Art, bei der die erwähnten Nachteile vermieden, d.h. die Mittel zur Kühlung hinsichtlich Aufbau und Betrieb weniger aufwendig sind.

Diesen Zweck erfüllt die Apparatur nach der Erfindung, welche durch die im Patentanspruch 1 angegebenen Merkmale gekennzeichnet ist.

Der geschlossene Kühlmittelkreislauf hat den Vorteil, dass das teure Kühlmittel nicht laufend verbraucht wird, sondern zyklisch wiederverwendet werden kann. Ausserdem ist für eine wirksame Kühlung ein Kühlbetrieb mit weniger extrem tiefen Temperaturen des gasförmigen Kühlmittels möglich als im Falle von Flüssiggas, da eine geringere Temperatur durch eine entsprechende Erhöhung des Durchsatzes ausgeglichen werden kann, und zwar ohne Mehrverbrauch an Kühlmittel. Mit einem erhöhten Kühlgasdurchsatz lässt sich auch eine Vereinfachung im Aufbau der im Behälter angeordneten Kühlvorrichtung erreichen, indem diese so ausgebildet sein kann, dass der Wirkungsbereich des von dieser erzeugten Kühlgasstromes den ganzen Arbeitsbereich erfasst. Eine derartige, z.B. mit mehreren Ausströmdüsen ausgerüstete Kühlvorrichtung kann im Behälter fest angeordnet sein, wodurch die bei der bekannten Apparatur erforderlichen Mittel zur Bewegung der Kühlvorrichtung und zur Nachfolgesteuerung derselben entfallen.

Unter diesem Aspekt besteht eine bevorzugte Ausführungsform der erfindungsgemässen Apparatur darin, dass für das Betriebsgas zur Aufrechterhaltung der Gasatmosphäre innerhalb des Behälters ebenfalls ein geschlossener Kreislauf vorgesehen ist, der mit dem Kühlgaskreislauf gekoppelt ist. Wenn diese beiden Kreisläufe zudem Einrichtungen zur Gasreinigung enthalten, erreicht man auf diese Weise eine fortlaufende Erneuerung der Gasatmosphäre im Behälter. Zur Deckung von Gasverlusten können die beiden Kreisläufe ferner dauernd oder periodisch mit einer gemeisamen Gasquelle verbunden sein.

Die beiden Kreisläufe unterscheiden sich im wesentlichen nur dadurch, dass der Gasdurchsatz im Kühlmittelkreislauf um ein Vielfaches höher ist als im Kreislauf des Betriebsgases. Zur Erzielung der erforderlichen Fördermenge ist in den Kühlmittelkreislauf vorzugsweise eine Umwälzpumpe eingeschaltet. Ferner kann im Kühlmittelkreislauf ein Wärmetauscher vorgesehen sein, der die Temperatur des gebrauchten Kühlmittels jeweils wieder auf den erforderlichen Wert herabsetzt.

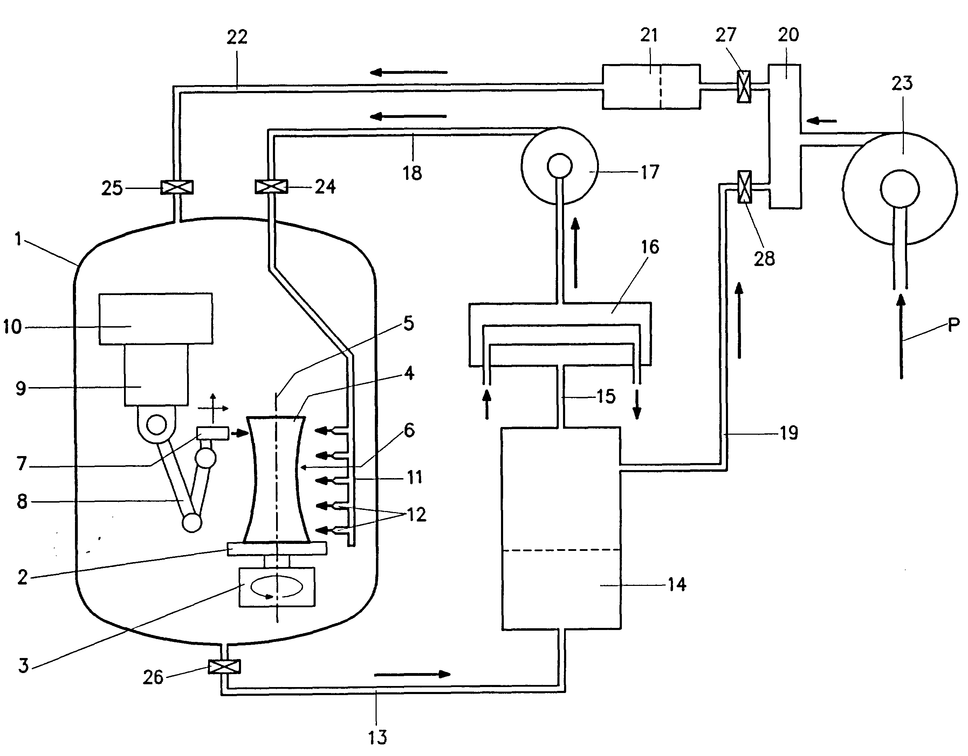

In der Zeichnung ist ein Ausführungsbeispiel der Erfindung schematisch dargestellt.

Als Hauptteil der gezeigten Apparatur ist ein gasdichter Behälter 1 vorgesehen, in dem z.B. eine inerte Gasatmosphäre erzeugt und für die Dauer einer Arbeitsphase aufrechterhalten wird. Es ist aber auch möglich, dem inerten Gas ein reaktives Gas zuzumischen, je nach Art der zu erzeugenden Beschichtung. In dem Behälter 1 befindet sich ein drehbarer Schemel 2, welcher von einem Antriebsmotor 3 in Drehung versetzt werden kann und auf dem das Werkstück 4 auf nicht näher dargestellte Weise fixiert ist. Im vorliegenden Beispiel handelt es sich um ein rotationssymmetrisches Werkstück 4, welches im Betrieb des Antriebsmotors 3 um die gemeinsame vertikale Achse 5 rotiert. Für die plasmathermische Bearbeitung der Oberfläche, im vorliegenden Beispiel der Mantelfläche 6 dieses Werkstücks 4, ist ein Plasmatron 7 vorgesehen, dessen Plasmastrahl gegen die Mantelfläche 6 gerichtet ist. Das Plasmatron 7 ist bezüglich der Rotationsachse 5 radial und achsial beweglich, damit dasselbe auf einer Bahn entlang der Mantellinie des Werkstückes mit konstantem Abstand zur Werkstückoberfläche geführt werden kann. Zu diesem Zweck ist das Plasmatron 7 am freien Ende eines Gelenkarms 8 angeordnet, welcher in an sich bekannter Weise mit Antriebsmitteln 9 getriebemässig verbunden ist. Diese nicht näher dargestellten Antriebsmittel 9 sind an einem ortsfesten Sockel 10 befestigt.

Auf der dem Plasmatron 7 abgewandten Seite des Werkstücks 4 ist eine mit Kühlgas betriebene Kühlvorrichtung 11 fest angeordnet, welche mehrere, mit gleichmässigem Abstand übereinander angeordnete Ausströmdüsen 12 aufweist und mit diesen einen Kühlgasstrom erzeugt, welcher sich in Richtung der Achse 5 über die ganze Länge des Werkstücks 4 erstreckt. Die Kühlvorrichtung 11 hat also einen Wirkungsbereich, welcher den ganzen Bearbeitungsbereich des Werkstücks erfasst.

Das zum Betrieb der Apparatur verwendete Gas, z.B. Stickstoff, Argon oder Helium oder ein Gemisch solcher bzw. weiterer Gase, dient im vorliegenden Beispiel sowohl als Betriebsgas zur Erzeugung und Aufrechterhaltung einer definierten Gasatmosphäre im Behälter 1 als auch als Kühlgas zum Kühlen der bearbeiteten Oberfläche des Werkstücks 4. Das Betriebsgas und das Kühlgas zirkulieren je in einem Kreislauf, welche miteinander gekoppelt sind, und zwar durch eine gemeinsame Ausgangsleitung 13, über welche das Gas dem Behälter 1 entnommen und einem Filter 14 zur Gasreinigung zugeführt wird.

Ein Teil des gereinigten Gases strömt als Kühlgas in einem ersten Kreislauf über die Leitung 15 durch einen Wärmetauscher 16, in welchem die Temperatur des Kühlgases herabgesetzt wird. Mittels einer Umwälzpumpe 17 wird das auf die Kühltemperatur gebrachte Kühlgas in der erforderlichen Menge pro Zeiteinheit durch die in den Behälter 1 führende Leitung 18 der Kühlvorrichtung 11 zugeleitet.

Ein anderer Teil des gereinigten Gases strömt als Betriebsgas in einem zweiten Kreislauf durch die Leitung 19 in eine Sammelleitung 20, einen weiteren Filter 21 und durch die Leitung 22 in den Behälter 1.

Das zum Auffüllen der Apparatur und zur Deckung von Verlusten benötigte Gas oder Gasgemisch wird einer nicht dargestellten Gasquelle entnommen und gelangt über eine Pumpe 23 in die Sammelleitung 20.

Zur Steuerung der Gaszufuhr zum Behälter 1 und der Gasabfuhr aus demselben sind die Ventile 24, 25 bzw. 26 in den betreffenden Leitungen 18, 22 und 13 vorgesehen, während die Ventile 27 und 28 den Gasaustausch über die Sammelleitung 20 regeln.

Normalerweise enthält die Apparatur ausserdem Einrichtungen, welche vor der Entnahme des bearbeiteten Werkstücks aus dem Behälter das darin enthaltene Gas absaugen und wegführen oder später in die Kreisläufe zurückführen, und Einrichtungen, mit denen der Behälter in den Arbeitspausen mit gereinigter Luft ausgeblasen wird. Alle Einrichtungen dieser Art sind an sich bekannt und in der Zeichnung nicht dargestellt, da sie für die Erfindung nicht wesentlich sind.

## Patentansprüche

1. Apparatur zur plasmathermischen Oberflächenbearbeitung von Werkstücken (4) aus thermisch empfindlichem Material in einer inerten Gasatmosphäre, mit einem gasdichten, den Arbeitsplatz umschliessenden Behälter (1), einem drehbaren Werkstückträger (2), einem Plasmatron (7) und Mitteln (8, 9) zur Positionierung desselben bezüglich der mit dem Plasmastrahl fortlaufend zonenweise zu bearbeitenden Werkstückoberfläche sowie mit einer während der Bearbeitung betriebenen Kühlanlage (11, 14, 16, 17) mit einer im Behälter (1) angeordneten Kühlvorrichtung (11, 12) zum Kühlen der jeweils bearbeiteten Werkstückoberflächenzone durch Beaufschlagen derselben mit einem Kühlmittelstrahl, wobei die Anordnung so getroffen ist, dass die Einwirkungszone des Kühlmittelstrahls der auf der Werkstückoberfläche wandernden Einwirkungszone des Plasmastrahls unmittelbar nachfolgt, dadurch gekennzeichnet, dass die Kühlvorrichtung im Behälter (1) stationär angeordnet und in einen geschlossenen, separaten Kühlmittelkreislauf (1, 13, 15, 18) eingeschaltet ist, und dass das darin zirkulierende Kühlmittel ein Teil des die Gasatmosphäre im Behälter bestimmenden Betriebsgases oder wenigstens ein diese Gasatmosphäre mitbestimmendes Gas ist.

2. Apparatur nach Anspruch 1, dadurch gekennzeichnet, dass für das Betriebsgas zur Aufrechterhaltung der inerten Gasatmosphäre innerhalb des Behälters (1) ebenfalls ein geschlossener Kreislauf /1, 13, 14, 19, 20, 22) vorgesehen ist, der mit dem Kühlgaskreislauf (1, 13, 15, 18) gekoppelt ist.

3. Apparatur nach Anspruch 2, dadurch gekennzeichnet, dass der Betriebsgaskreislauf (1, 13, 14, 19, 20, 22) und der Kühlgaskreislauf (1, 13, 15, 18) Einrichtungen (14, 21) zur Gasreinigung enthalten.

4. Apparatur nach Anspruch 2, dadurch gekennzeichnet, dass der Betriebsgaskreislauf und der Kühlgaskreislauf dauernd oder periodisch mit einer gemeinsamen Gasquelle verbunden sind.

5. Apparatur nach einem der vorhergehenden Ansprüche, dadurch gekennzeichnet, dass in den Kühlgaskreislauf eine Umwälzpumpe (17) eingeschaltet ist.

6. Apparatur nach einem der vorhergehenden Ansprüche, dadurch gekennzeichnet, dass in den Kühlgaskreislauf ein die Temperatur des Kühlgases herabsetzender Wärmetauscher (16) eingeschaltet ist.

7. Apparatur nach einem der vorhergehenden Ansprüche, dadurch gekennzeichnet, dass sich der Wirkungsbereich der Kühlvorrichtung (11, 12) über den ganzen Arbeitsbereich des Plasmatrons (7) erstreckt.

## Claims

1. Apparatus for thermal plasma processing of the surface of work-pieces (4) consisting of thermally sensitive material in an inert gas atmosphere, with a gas-tight container (1) surrounding the operating position, a rotary work-piece support (2), a plasmatron (7) and means (8, 9) for positioning the latter with respect to the surface of the work-piece to be processed continuously in zones by the plasma beam as well as with a cooling system (11, 14, 16, 17) operated during processing, with a cooling device (11, 12) located in the container (1) for cooling the respectively processed work-piece surface area by supplying the latter with a coolant jet, the arrangement being such that the zone of action of the coolant jet directly follows the zone of action of the plasma beam travelling the work-piece surface, characterised in that the cooling device is arranged in a stationary manner in the container (1) and is incorporated in a closed, separate coolant circuit (1, 13, 15, 18) and that the coolant circulating therein is a part of the operating gas defining the gas atmosphere in the container or at least a gas co-defining this gas atmosphere.

2. Apparatus according to Claim 1, characterised in that for the operating gas for maintaining the inert gas atmosphere within the container (1), a closed circuit (1, 13, 14, 19, 20, 22) is likewise provided, which is connected to the cooling gas circuit (1, 13, 15, 18).

3. Apparatus according to Claim 2, characterised in that the operating gas circuit (1, 13, 14, 19, 20, 22) and the cooling gas circuit (1, 13, 15, 18) contain devices (14, 21) for purifying the gas.

4. Apparatus according to Claim 2, characterised in that the operating gas circuit and the cooling gas circuit are connected permanently or periodically to a common gas source.

5. Apparatus according to one of the preceding Claims, characterised in that a circulating pump (17) is incorporated in the cooling gas circuit.

6. Apparatus according to one of the preceding Claims, characterised in that a heat exchanger (16) reducing the temperature of the cooling gas is incorporated in the cooling gas circuit.

7. Apparatus according to one of the preceding Claims, characterised in that the range of action of the cooling device (11, 12) extends over the entire working region of the plasmatron (7).

## Revendications

1. Appareil pour le traitement thermique par plasma de la surface de pièces (4) à base de matériau sensible à la chaleur dans une atmosphère gazeuse inerte, équipé d'un récipient (1) étanche au gaz et entourant le poste de travail, d'un porte-pièce (2) rotatif, d'un plasmatron (7) et de moyens (8, 9) pour le positionnement de celui-ci par rapport à la surface de pièce à traiter de façon continue et par zones avec le jet de plasma et d'une installation de refroidissement (11, 14, 16, 17) exploitée pendant le traitement avec un dispositif de refroidissement (11, 12) disposé dans le récipient (1) pour le refroidissement de la zone superficielle traitée de la pièce concernée par alimentation de cette zone avec un jet d'agent réfrigérant, l'agencement étant choisi de telle façon que la zone d'influence, se déplaçant à la surface de la pièce, du jet de l'agent réfrigérant suive directement la zone d'influence du jet de plasma, caractérisé en ce que le dispositif de refroidissement est disposé de façon fixe dans le récipient (1) et est mis dans un circuit d'agent réfrigérant (1, 13, 15, 18) fermé et séparé et en ce que l'agent réfrigérant circulant dedans est une partie du gaz de service qui détermine l'atmosphère gazeuse dans le récipient ou ait au moins un gaz qui participe à la détermination de cet atmosphère gazeuse.

2. Appareil selon la revendication 1, caractérisé en ce que, pour le gaz de service et pour conserver l'atmosphère gazeuse inerte à l'intérieur du récipient (1), il est prévu également un circuit fermé (1, 13, 14, 19, 20, 22) qui est couplé avec le circuit du gaz de refroidissement (1, ,13, 15, 18).

3. Appareil selon la revendication 2, caractérisé en ce que le circuit du gaz de service (1, 13, 14, 19, 20, 22) et le circuit du gaz de refroidissement (1, 13, 15, 18) contiennent des dispositifs (14, 21) pour le nettoyage du gaz.

4. Appareil selon la revendication 2, caractérisé en ce que le circuit du gaz de service et le circuit du gaz de refroidissement sont reliés en permanence ou périodiquement à une source de gaz commune.

5. Appareil selon l'une quelconque des revendications précédentes, caractérisé en ce qu'une pompe de circulation (17) est branchée dans le circuit du gaz de refroidissement.

6. Appareil selon l'une quelconque des revendications précédentes, caractérisé en ce qu'un échangeur de chaleur (16) abaissant la température du gaz de refroidissement est branché dans le circuit du gaz de refroidissement.

7. Appareil selon l'une quelconque des revendications précédentes, caractérisé en ce que la zone d'action du dispositif de refroidissement (11, 12) s'étend sur toute la plage de travail du plasmatron (7).
